# EUROPEAN PATENT APPLICATION

(11) **EP 4 772 671 A1**
(43) Date of publication of application: **08.07.2026**
(21) Application number: 24887514.8
(22) Date of filing: 06.08.2024
(51) Int. Cl.: C23C 16/509, C23C 16/455

(54) **LARGE-AREA PLASMA DISCHARGE STRUCTURE AND VACUUM COATING DEVICE**

(30) Priority: 08.11.2023 CN 202311481852
(71) Applicant: Suzhou Maxwell Technologies Co., Ltd., Suzhou, Jiangsu 215200 (CN); Suzhou Maizheng Technology Co., Ltd, Suzhou, Jiangsu 215200 (CN)
(72) Inventor: CAO, Xinmin, Suzhou, Jiangsu 215200 (CN); CHEN, Chen, Suzhou, Jiangsu 215200 (CN); ZHOU, Jian, Suzhou, Jiangsu 215200 (CN); WANG, Dengzhi, Suzhou, Jiangsu 215200 (CN); TIAN, Gangyu, Suzhou, Jiangsu 215200 (CN); ZHANG, Bin, Suzhou, Jiangsu 215200 (CN); FANG, Xianfei, Suzhou, Jiangsu 215200 (CN); WANG, Qingsong, Suzhou, Jiangsu 215200 (CN); WANG, Fengming, Suzhou, Jiangsu 215200 (CN)
(74) Representative: Reddie & Grose LLP
(86) International application number: PCT/CN2024/110171
(87) International publication number: WO 2025/097892

(57) **Abstract**

A large-area plasma discharge structure and a vacuum coating device, said structure comprising an upper electrode module (110) and a lower electrode module (120), a coating electric field being formed between the upper electrode module (110) and the lower electrode module (120). The upper electrode module comprises a back plate (111), a spraying head (112) and dielectric plates (113). The back plate (111) is connected to a radio frequency power supply (300) and is used to introduce process gas; the spray head (112) is mounted on the back plate (111), and the side of the spray head (112) facing away from the back plate (111) has a recessed portion (1122); the dielectric plates (113) are detachably connected to the spray head (112), the sides of the dielectric plates (113) close to the spray head (112) face the recessed portion (1122), there are multiple dielectric plates (113), and the multiple dielectric plates (113) overlap each other to form a lower surface of the entire upper electrode module (110). By means of the described configuration, a vacuum discharge area having a large middle space and a small edge space is formed between the dielectric plates (113) and the spray head (112), weakening the influence of a transverse standing wave effect of an electrical signal in the radio frequency source, ensuring uniformity of a coating electrical field formed between a cathode module and an anode module, and improving uniformity of a film layer in a coating process.

## Description

### TECHNICAL FIELD

The present application relates to the technical field of vacuum film deposition, in particular to a large-area plasma discharge structure and vacuum film deposition apparatus.

### BACKGROUND

With the development of solar cell technology, the development of high-efficiency solar cells has become the research focus of major enterprises. Among them, heterojunction solar cells have emerged as a research hot spot in the industry as a new type of technology. A key feature of this technology is the use of Plasma Enhanced Chemical Vapor Deposition (PECVD) to deposit amorphous silicon or microcrystalline silicon films on monocrystalline silicon wafers. In the specific preparation process, process gas enters the vacuum film deposition chamber through the gas inlet of the cathode showerhead, gradually diffuses to the surface of the silicon wafer to be deposited, and under the action of the electric field excited by the radio frequency power supply, the process gas generates plasma and undergoes chemical reactions, forming an amorphous silicon or microcrystalline silicon film on the surface of the silicon wafer to be deposited.

Currently, to achieve cost reduction and efficiency improvement of heterojunction solar cells, enterprises usually adopt large-area cathode showerheads to deposit large-area films on the surfaces of multiple monocrystalline silicon wafers, thereby improving the film deposition efficiency of a single batch. However, the resulting large-area films often suffer from poor uniformity, such as being thicker in the middle and thinner at the edges or thinner in the middle and thicker at the edges, which reduces the yield of heterojunction solar cells.

### SUMMARY

Based on this, it is necessary to address the problem of poor uniformity existing in the current production of large-area deposited films by providing a large-area plasma discharge structure and vacuum film deposition apparatus.

A large-area plasma discharge structure comprises an upper electrode assembly and a lower electrode assembly, wherein a film deposition electric field is formed between the upper electrode assembly and the lower electrode assembly. The upper electrode assembly includes:

a back plate connected to a radio frequency power supply and used for introducing process gas;

a showerhead mounted on the back plate, with a recessed part on the side facing away from the back plate;

a plurality of dielectric plates detachably connected to the showerhead, wherein the side of each dielectric plate close to the showerhead faces the recessed part, and the plurality of dielectric plates are lap-jointed to form the lower surface of the entire upper electrode assembly.

In one embodiment, the dielectric plate comprises an electrical conductor and a dielectric layer covering the surface of the electrical conductor.

In one embodiment, the relative dielectric constant of the dielectric layer is 2-1000.

In one embodiment, the relative dielectric constant of the dielectric layer is preferably 2-40.

In one embodiment, the dielectric plate is made of a ceramic material.

In one embodiment, the ceramic material is at least one selected from the group consisting of talc ceramic, forsterite ceramic, cordierite ceramic, spinel ceramic, mullite ceramic, glass ceramic, sialon ceramic, yttrium fluoride ceramic, silicon nitride ceramic, magnesium oxide ceramic, beryllium oxide ceramic, hafnium oxide ceramic, cerium oxide ceramic, boron nitride ceramic, boron carbide ceramic, aluminum oxide ceramic, yttrium oxide ceramic, aluminum nitride ceramic, silicon carbide ceramic, zirconium oxide ceramic, and bismuth oxide ceramic.

In one embodiment, the dielectric plate has a rectangular structure, with both length and width ranging from 40 mm to 400 mm, and thickness ranging from 0.5 mm to 10 mm.

In one embodiment, the length and width of the dielectric plate are both ranging from 100 mm to 250 mm, and the thickness ranging from 1 mm to 5 mm.

In one embodiment, each dielectric plate is provided with 2 upper grooves and 2 lower grooves on its four edges, and one upper groove of adjacent dielectric plates is engaged in a lap joint with one lower groove of the other dielectric plate.

In one embodiment, the dielectric plate is provided with mounting through-holes penetrating through the dielectric plate along the thickness direction thereof; the showerhead is provided with mounting holes; and connecting fasteners pass through the mounting through-holes and the mounting holes to detachably connect the dielectric plate and the showerhead as an integral assembly.

In one embodiment, the first end of the connecting fastener away from the showerhead does not extend beyond the surface of the dielectric plate facing away from the showerhead.

In one embodiment, the side of the showerhead facing the dielectric plate is provided with receiving holes; the upper electrode assembly further includes positioning pins, one end of each positioning pin is located in the corresponding receiving hole, and the other end of each positioning pin abuts against the dielectric plate.

In one embodiment, the recessed part of the showerhead has an arcuate or step-like structure, and the distance between the showerhead and the dielectric plate gradually decreases from the central area to the edge area.

The present application also provides a vacuum film deposition apparatus, which comprises a vacuum chamber, a radio frequency power supply, and the large-area plasma discharge structure according to any one of the above embodiments, wherein:

The large-area plasma discharge structure is installed in the vacuum chamber, and at least one of the upper electrode assembly and the lower electrode assembly included in the large-area plasma discharge structure is connected to the radio frequency power supply.

The above-mentioned vacuum film deposition apparatus includes the large-area plasma discharge structure. By arranging a plurality of lap joint dielectric plates, the area size of the dielectric plates can be extended arbitrarily, making it convenient to obtain large-area dielectric plates. When the large-area dielectric plates are applied in the large-area plasma discharge structure, by arranging the dielectric plates to face the recessed part of the showerhead, a vacuum discharge region with a large central space and small edge spaces is formed between the dielectric plates and the showerhead. This can weaken the influence of the transverse standing wave effect of the electrical signal output by the radio frequency power supply, ensure the uniformity of the film deposition electric field formed between the upper electrode assembly and the lower electrode assembly, thereby improving the uniformity of the film during the film deposition process of the large-area plasma discharge structure, alleviating the problem of poor film uniformity, and increasing the yield of heterojunction solar cells.

### BRIEF DESCRIPTION OF THE DRAWINGS

FIG. 1 is a schematic structural diagram of a vacuum film deposition apparatus provided by the present application.
FIG. 2 is a schematic diagram of the installation structure of a showerhead and a dielectric plate provided by the present application.
FIG. 3 is a schematic structural diagram of the showerhead in FIG. 2.
FIG. 4 is a schematic structural diagram of the showerhead provided by the present application from another perspective.
FIG. 5 is a schematic diagram of a lap joint structure of a plurality of dielectric plates provided by the present application.
FIG. 6 is a schematic structural diagram of the dielectric plate in FIG. 5.
FIG. 7 is a schematic diagram of another installation structure of a showerhead and a dielectric plate provided by the present application.
FIG. 8 is a schematic structural diagram of the showerhead in FIG. 7.

### Description of elements in the drawings:

10. Vacuum film deposition apparatus;
100. Large-area plasma discharge structure;
110. Upper electrode assembly;
111. Back plate;
112. Showerhead;
1121. First gas distribution hole;
1122. Recessed part;
1123. mounting hole;
1124. receiving hole;
113. Dielectric plate;
1131. Second gas distribution hole;
1132. Upper groove;
1133. Lower groove;
1134. Mounting through-hole;
114. Vacuum discharge region;
115. Connecting fastener;
116. Positioning pin;
120. Lower electrode assembly;
121. Tray;
122. Heating plate;
200. Vacuum chamber;
300. Radio frequency power supply;
400. Gas source.

### DETAILED DESCRIPTION OF THE EMBODIMENTS

To make the above objectives, features, and advantages of the present application more clearly understandable, the specific implementations of the present application are described in detail below with reference to the accompanying drawings. Many specific details are set forth in the following description to facilitate a full understanding of the present application. However, the present application can be implemented in many other ways different from those described herein, and those skilled in the art can make similar improvements without departing from the connotation of the present application. Therefore, the present application is not limited to the specific embodiments disclosed below.

In the description of the present application, it should be understood that if the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc., appear, the orientation or positional relationship indicated by these terms is based on the orientation or positional relationship shown in the accompanying drawings. It is only for the convenience of describing the present application and simplifying the description, and does not indicate or imply that the device or element referred to must have a specific orientation, be constructed and operated in a specific orientation, and therefore cannot be understood as a limitation on the present application.

In addition, if the terms "first" and "second" appear, these terms are only used for descriptive purposes and cannot be understood as indicating or implying relative importance or implicitly indicating the number of indicated technical features. Thus, the features defined with "first" and "second" may explicitly or implicitly include at least one such feature. In the description of the present application, if the term "plurality" appears, the meaning of "plurality" is at least two, such as two, three, etc., unless otherwise explicitly specified.

In the present application, unless otherwise clearly specified and limited, if the terms "installation", "connected", "connection", "fixed", etc., appear, these terms should be understood in a broad sense. For example, it may be a fixed connection, a detachable connection, or an integral structure; it may be a mechanical connection or an electrical connection; it may be a direct connection or an indirect connection through an intermediate medium, and it may be the communication between the interiors of two components or the interaction relationship between two components, unless otherwise explicitly limited. For those of ordinary skill in the art, the specific meanings of the above terms in the present application can be understood according to specific circumstances.

In the present application, unless otherwise clearly specified and limited, if there is a description such as "the first feature is on or below the second feature", its meaning may be that the first and second features are in direct contact, or the first and second features are in indirect contact through an intermediate medium. Moreover, the first feature being "on top of", "above", or "over" the second feature may mean that the first feature is directly above or obliquely above the second feature, or simply means that the horizontal height of the first feature is higher than that of the second feature. The first feature being "underneath", "below", or "beneath" the second feature may mean that the first feature is directly below or obliquely below the second feature, or simply means that the horizontal height of the first feature is lower than that of the second feature.

It should be noted that if an element is referred to as being "fixed to" or "disposed on" another element, it may be directly on the other element or there may be an intermediate element. If an element is considered to be "connected" to another element, it may be directly connected to the other element or there may be an intermediate element at the same time. If present, the terms "vertical", "horizontal", "upper", "lower", "left", "right", and similar expressions used in the present application are only for descriptive purposes and do not indicate the only implementation manner.

The applicant's research found that: currently, to achieve cost reduction and efficiency improvement of heterojunction solar cells, enterprises usually adopt large-area cathode showerheads to deposit large-area films on the surfaces of multiple monocrystalline silicon wafers. The length and width of mainstream showerhead sizes are both more than one meter, so as to improve the film deposition efficiency of a single batch. However, the resulting large-area films often suffer from poor uniformity, such as being thicker in the middle and thinner at the edges or thinner in the middle and thicker at the edges, which reduces the yield of heterojunction solar cells.

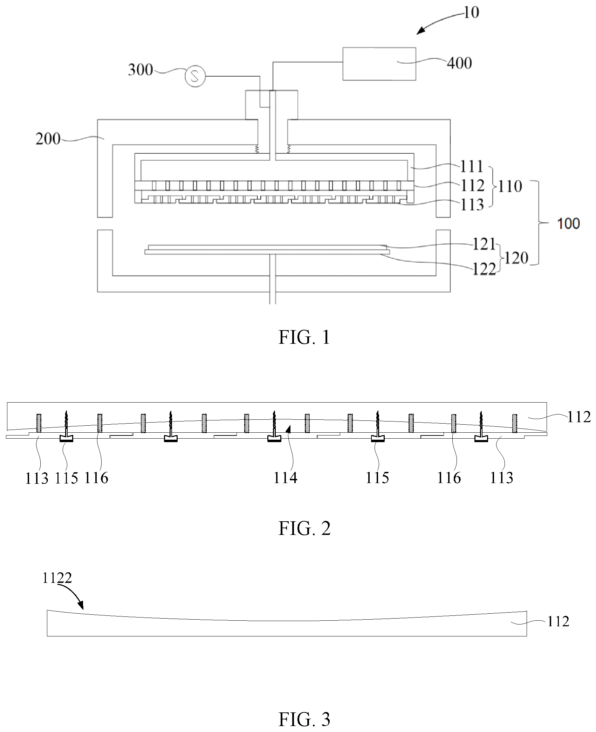

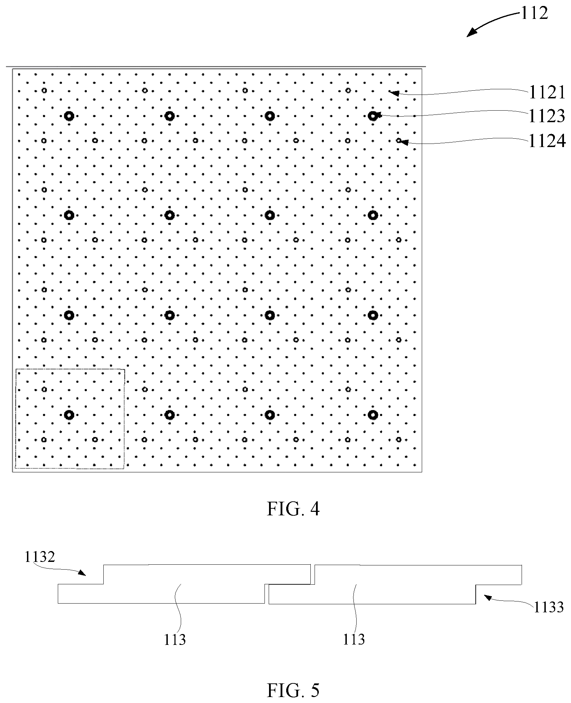

To this end, please refer to FIGS. 1, 2, 3, and 4. FIG. 1 illustrates a schematic structural diagram of a vacuum film deposition apparatus 10 in an embodiment of the present application, FIG. 2 illustrates a schematic diagram of the installation structure of a showerhead 112 and a dielectric plate 113 in an embodiment of the present application, FIG. 3 is a schematic structural diagram of the showerhead 112 in FIG. 2, and FIG. 4 illustrates a schematic structural diagram of the showerhead 112 from another perspective in an embodiment of the present application.

A large-area plasma discharge structure 100 provided in an embodiment of the present application is applied to a vacuum film deposition apparatus 10. The vacuum film deposition apparatus 10 includes a vacuum chamber 200. The large-area plasma discharge structure 100 includes an upper electrode assembly 110 and a lower electrode assembly 120 disposed in the vacuum chamber 200, and a film deposition electric field is formed between the upper electrode assembly 110 and the lower electrode assembly 120. In specific arrangement, the upper electrode assembly 110 and the lower electrode assembly 120 are arranged in parallel and opposite to each other in the vacuum chamber 200. The lower electrode assembly 120 includes a tray 121 and a heating plate 122 connected to the tray 121, and the side of the tray 121 facing away from the heating plate 122 is used to carry the silicon wafers to be deposited.

The upper electrode assembly 110 includes a back plate 111, a showerhead 112, and a dielectric plate 113 arranged in sequence. The back plate 111 is connected to a radio frequency power supply 300 and used for introducing process gas. Specifically, the back plate 111 is in communication with a gas source 400, and the gas source 400 contains process gas. The silicon wafers to be deposited are located in the film deposition electric field formed by the dielectric plate 113 and the tray 121. In specific arrangement, the showerhead 112 is provided with first gas distribution holes 1121 that penetrate through the showerhead 112 along the thickness direction thereof. The dielectric plate 113 is provided with second gas distribution holes 1131 that penetrate through the dielectric plate 113 along the thickness direction thereof. The first gas distribution holes 1121 and the second gas distribution holes 1131 form gas flow channels, and the first gas distribution holes 1121 and the second gas distribution holes 1131 may be arranged directly opposite to each other. The process gas flows from the back plate 111, passes through the first gas distribution holes 1121 of the showerhead 112, then diffuses to the surface of the silicon wafers to be deposited along the second gas distribution holes 1131. Under the action of the film deposition electric field, the process gas generates plasma, and the plasma undergoes chemical reactions to form the required amorphous silicon or microcrystalline silicon film on the surface of the silicon wafers to be deposited.

The showerhead 112 is mounted on the back plate 111, and the side of the showerhead 112 facing away from the back plate 111 is provided with a recessed part 1122. The recessed part 1122 may have an arcuate structure. In specific arrangement, the surface of the recessed part 1122 is an arc surface, specifically a circular arc or an elliptical arc, and the arc surfaces are arranged symmetrically. The dielectric plate 113 is detachably connected to the showerhead 112, and the side of the dielectric plate 113 close to the showerhead 112 faces the recessed part 1122, that is, the recessed part 1122 of the showerhead 112 faces the dielectric plate 113. By the above arrangement, a vacuum discharge region 114 is formed between the dielectric plate 113 and the showerhead 112. Specifically, the showerhead 112 and the dielectric plate 113 form a vacuum discharge region 114 with a large central space and small edge spaces, which is conducive to weakening the influence of the transverse standing wave effect of the electrical signal in the radio frequency power supply, ensuring the uniformity of the film deposition electric field formed between the upper electrode assembly 110 and the lower electrode assembly 120, thereby improving the uniformity of the film during the film deposition process. In specific arrangement of the dielectric plate 113 and the showerhead 112, the dielectric plate 113 is directly opposite to the showerhead 112, the length of the dielectric plate 113 is not less than the length of the recessed part 1122 in the showerhead 112, and there is a set distance between the dielectric plate 113 and the showerhead 112.

The number of the dielectric plates 113 is plural, and the plurality of dielectric plates 113 are lap-jointed to form the lower surface of the entire upper electrode assembly 110. It should be noted that the area size of the dielectric plates 113 can be arbitrarily extended through the lap joint method, enabling the dielectric plates 113 to be applied in large-area discharge structures. Compared with integrally formed large-size dielectric plates 113, the large-size dielectric plates 113 obtained by lap joint are less prone to breakage or fragmentation. In specific arrangement, the specific number of dielectric plates 113 is set according to the required size of the dielectric plates 113, and the overall size formed by the plurality of dielectric plates 113 matches the size of the showerhead 112. As shown in FIG. 4, the dashed box area at the lower left corner is the area where the showerhead 112 corresponds to one dielectric plate 113.

For the above-mentioned large-area plasma discharge structure 100, the area size of the dielectric plates 113 can be arbitrarily extended by arranging a plurality of lap-jointed dielectric plates 113, making it convenient to obtain large-area dielectric plates 113. When the large-area dielectric plates 113 are applied in the large-area plasma discharge structure 100, by arranging the dielectric plates 113 to face the recessed part 1122 of the showerhead 112 (where the recessed part 1122 has an arcuate structure), a vacuum discharge region 114 with a large central space and small edge spaces is formed between the dielectric plates 113 and the showerhead 112. This can weaken the influence of the transverse standing wave effect of the electrical signal in the radio frequency power supply, ensure the uniformity of the film deposition electric field formed between the upper electrode assembly 110 and the lower electrode assembly 120, thereby improving the uniformity of the film during the film deposition process of the large-area plasma discharge structure 100, alleviating the problem of poor film uniformity, and increasing the yield of heterojunction solar cells.

To further ensure film deposition uniformity, a vacuum discharge region 114 with a relative dielectric constant of 1 is also formed between the dielectric plate 113 and the showerhead 112. It should be noted that the relative dielectric constant of the vacuum discharge region 114 is around 1, specifically values close to 1 such as 1.1 and 1.2. The vacuum discharge region 114 with a relative dielectric constant close to 1 formed between the showerhead 112 and the dielectric plate 113 is conducive to compensating for the voltage in the plasma discharge gap, thereby ensuring the uniformity of the film deposition electric field, alleviating the problem of poor film uniformity, and increasing the yield of heterojunction solar cells.

Based on this, to conveniently form a vacuum discharge region 114 with a relative dielectric constant of 1 between the dielectric plate 113 and the showerhead 112, in a preferred embodiment, the dielectric plate 113 includes an electrical conductor and a dielectric layer covering the surface of the electrical conductor. In specific arrangement, the material of the dielectric layer can be one of dielectric materials such as silicon nitride, magnesium oxide, beryllium oxide, hafnium oxide, cerium oxide, boron nitride, boron carbide, aluminum oxide, yttrium oxide, aluminum nitride, silicon carbide, zirconium oxide, bismuth oxide, yttrium fluoride, aluminum silicon oxynitride, Teflon, and sialon. With the above arrangement, the dielectric layer has high corrosion resistance and excellent chemical stability, protecting the electrical conductor while extending the service life of the entire dielectric plate 113. The material of the electrical conductor can be at least one of conductive materials such as aluminum, nickel, stainless steel, aluminum alloy, nickel-chromium alloy, silicon carbide, silicon nitride, and gallium nitride. Through the above arrangement, the dielectric plate 113 composed of the electrical conductor and the dielectric layer can conveniently form a vacuum discharge region 114 with a relative dielectric constant of 1 between itself and the showerhead 112, compensate for the voltage in the plasma discharge gap, ensure the uniformity of the film deposition electric field, thereby alleviating the problem of poor film uniformity and increasing the yield of heterojunction solar cells. It should be noted that the dielectric layer on the outer layer of the electrical conductor can be prepared by means of evaporation, sputtering, chemical vapor deposition (CVD), spray coating, electrochemistry deposition, metal anodization, etc.

To ensure the dielectric layer has low thermal loss while facilitating the elimination of film deposition electric field inhomogeneity, specifically, the relative dielectric constant of the dielectric layer is 2-1000. In specific arrangement, the relative dielectric constant of the dielectric layer can be 3, 5, 7, 9, 20, 50, 90, 200, or any value between 2-1000. This is the optimal parameter range of the dielectric layer's relative dielectric constant obtained by the applicant through repeated experiments. When the relative dielectric constant of the dielectric layer is less than 2, the thermal loss of the dielectric layer itself is relatively large; when the relative dielectric constant is greater than 1000, it is difficult to eliminate the inhomogeneity of the film deposition electric field. The present application preferably sets the relative dielectric constant of the dielectric layer to 2-1000.

To ensure the dielectric layer has appropriate toughness, the thickness of the dielectric layer ranges from 0.3 mm to 5 mm. In specific arrangement, the thickness can be 0.8 mm, 2 mm, 2.8 mm, 3.6 mm, 4 mm, 4.5 mm, or any value between 0.3 mm-5 mm. This is also the optimal parameter range of the dielectric layer's thickness derived from the applicant's repeated experiments. The above arrangement ensures the dielectric layer has toughness and makes it less prone to fragmentation and damage.

In addition to the structure where the dielectric layer covers the electrical conductor, the dielectric plate 113 can also be entirely made of a ceramic dielectric material. In a preferred embodiment, the ceramic material is at least one selected from the group consisting of talc ceramic, forsterite ceramic, cordierite ceramic, spinel ceramic, mullite ceramic, glass ceramic, sialon ceramic, yttrium fluoride ceramic, silicon nitride ceramic, magnesium oxide ceramic, beryllium oxide ceramic, hafnium oxide ceramic, cerium oxide ceramic, boron nitride ceramic, boron carbide ceramic, aluminum oxide ceramic, yttrium oxide ceramic, aluminum nitride ceramic, silicon carbide ceramic, zirconium oxide ceramic, and bismuth oxide ceramic. With the above arrangement, the dielectric plate 113 has good corrosion resistance and a certain degree of hardness, which helps extend its service life.

To ensure the ceramic dielectric plate 113 has low thermal loss while facilitating the elimination of film deposition electric field inhomogeneity, specifically, the relative dielectric constant of the dielectric plate 113 is 2-40. In specific arrangement, the relative dielectric constant can be 3, 7, 12, 21, 33, or any value between 2-40. This is the optimal parameter range of the dielectric plate's relative dielectric constant obtained by the applicant through repeated experiments. When the relative dielectric constant is less than 2, the thermal loss of the dielectric plate 113 itself is relatively large; when it is greater than 40, it is difficult to eliminate the inhomogeneity of the film deposition electric field. The present application preferably sets the relative dielectric constant of the dielectric plate 113 to 2-40.

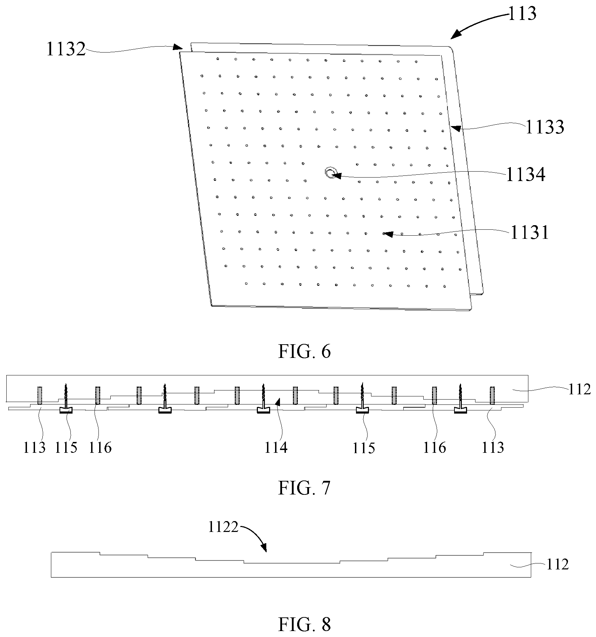

Referring to FIGS. 5 and 6, FIG. 5 is a schematic diagram of the lap joint structure of a plurality of dielectric plates 113 provided by the present application, and FIG. 6 is a schematic structural diagram of the dielectric plate 113 in FIG. 5. To save the cost of lap-jointed multiple dielectric plates 113, in a preferred embodiment, the dielectric plate 113 has a rectangular structure, with both length and width ranging from 40 mm to 400 mm, and thickness ranging from 0.5 mm to 10 mm. In specific arrangement, the length and width can be 50 mm, 80 mm, 150 mm, 200 mm, 300 mm, or any value between 40 mm-400 mm; the thickness can be 0.8 mm, 1.5 mm, 5 mm, 7.5 mm, or any value between 0.5 mm-10 mm.

It should be noted that when multiple dielectric plates 113 are combined into one body through lap joint, if the size of the dielectric plate 113 is too small, the installation time cost will increase, if the size is too large, the yield rate will decrease, leading to higher processing costs and increased fragility of the dielectric plate 113. An excessively thin dielectric plate 113 will also be prone to fragmentation, while an excessively thick one will increase the material cost for processing and its self-weight, resulting in increased installation difficulty. Based on this, the applicant has determined through repeated practice that the more preferred range for both length and width of the dielectric plate 113 is 100 mm-250 mm, and the more preferred thickness range is 1 mm-5 mm.

To facilitate lap joint between two adjacent dielectric plates 113, specifically, each dielectric plate 113 is provided with 2 upper grooves 1132 and 2 lower grooves 1133 on its four edges, and one upper groove 1132 of adjacent dielectric plates 113 is engaged in a lap joint with one lower groove 1133 of the other dielectric plate 113. In specific arrangement, the shapes of the upper grooves 1132 and lower grooves 1133 are generally set to rectangular. It should be noted that the shapes of the upper grooves 1132 and lower grooves 1133 are not limited to the above-mentioned rectangular; any shapes that can be joined to form a flat surface are acceptable.

To facilitate the detachable connection between the dielectric plate 113 and the showerhead 112, in a preferred embodiment, the dielectric plate 113 is provided with mounting through-holes 1134 that penetrate through the dielectric plate 113 along its thickness direction. The showerhead 112 is provided with mounting holes 1123, and connecting fasteners 115 pass through the mounting through-holes 1134 and the mounting holes 1123 to detachably connect the dielectric plate 113 and the showerhead 112 as an integral assembly. In specific arrangement, the mounting through-holes 1134 are generally aligned with the mounting holes 1123, and the number of mounting holes 1123 and connecting fasteners 115 is consistent with the number of mounting through-holes 1134. Each dielectric plate 113 is provided with at least one mounting through-hole 1134, which is generally opened at the center of the dielectric plate 113. However, the mounting through-hole 1134 is not limited to the center of the dielectric plate 113; it can be any part of the dielectric plate 113 or the lap joint portion of two adjacent dielectric plates 113.

It should be noted that the mounting through-holes 1134 on the dielectric plate 113 are displaced from the second gas distribution holes 1131 on the same plate. The number of second gas distribution holes 1131 is plural, and they are arranged at intervals on the dielectric plate 113. In specific arrangement, the plurality of second gas distribution holes 1131 can be arranged on the dielectric plate 113 at equal intervals or unequal intervals. It should be emphasized that when there are multiple second gas distribution holes 1131, there are also multiple corresponding first gas distribution holes 1121 on the showerhead 112. In specific arrangement, the plurality of first gas distribution holes 1121 can be distributed on the showerhead 112 at equal intervals or unequal intervals.

To ensure the flatness of the dielectric plate 113, specifically, the first end of the connecting fastener 115 away from the showerhead 112 does not extend beyond the surface of the dielectric plate 113 facing away from the showerhead 112. In specific arrangement, the material of the connecting fastener 115 is generally an insulating material, and the connecting fastener 115 can be an insulating screw, insulating stud, insulating bolt, or other fasteners. It should be noted that the surface of the dielectric plate 113 facing away from the showerhead 112 is the lower surface; the first end of the connecting fastener 115 does not protrude beyond the lower surface of the dielectric plate 113, which ensures the flatness of the lower surface of the dielectric plate 113, helps maintain the uniformity of the film deposition electric field, thereby improving the film uniformity and increasing the yield of heterojunction solar cells.

To ensure the horizontal arrangement of the dielectric plate 113, in a preferred embodiment, the side of the showerhead 112 facing the dielectric plate 113 is provided with receiving holes 1124. The upper electrode assembly 110 further includes positioning pins 116, one end of each positioning pin 116 is located in the corresponding receiving hole 1124, and the other end abuts against the dielectric plate 113. In specific arrangement, the material of the positioning pins 116 is generally an insulating material, and the number of positioning pins 116 is at least 3,specifically, 5, 8, 10, or more. Usually, two positioning pins 116 abut against one dielectric plate 113, and the number of positioning pins 116 is consistent with the number of receiving holes 1124 for receiving them. All receiving holes 1124 are arranged at intervals on the side of the showerhead 112 facing the dielectric plate 113, and this side of the showerhead 112 is provided with the recessed part 1122. To ensure that the ends of the positioning pins 116 facing away from the showerhead 112 are located on the same horizontal plane, the depth of the receiving holes 1124 along the length direction of the recessed part 1122 first decreases and then increases. Through the above arrangement, it is convenient to set the ends of the positioning pins 116 facing away from the showerhead 112 on the same horizontal plane, so that the dielectric plate 113 abutting against the positioning pins 116 remains horizontally arranged. This helps maintain the uniformity of the film deposition electric field, thereby improving the film uniformity and increasing the yield of heterojunction solar cells.

Referring to FIGS. 7 and 8, FIG. 7 is a schematic diagram of another installation structure of a showerhead 112 and a dielectric plate 113 provided by the present application, and FIG. 8 is a schematic structural diagram of the showerhead 112 in FIG. 7. To conveniently form a vacuum discharge region 114 with a large central space and small edge spaces between the showerhead 112 and the dielectric plate 113, in a preferred embodiment, the recessed part 1122 of the showerhead 112 has an arcuate or step-like structure, and the distance between the showerhead 112 and the dielectric plate 113 gradually decreases from the central area to the edge area. When the recessed part 1122 has a step-like structure, the cross-section of the recessed part 1122 is stepped, first descending and then ascending, and the recessed part 1122 is arranged symmetrically.

Referring again to FIG. 1, an embodiment of the present application further provides a vacuum film deposition apparatus 10. The vacuum film deposition apparatus 10 includes a vacuum chamber 200, a radio frequency power supply, and the large-area plasma discharge structure 100 according to any one of the above embodiments. The large-area plasma discharge structure 100 is installed in the vacuum chamber 200. At least one of the upper electrode assembly 110 and the lower electrode assembly 120 included in the large-area plasma discharge structure 100 is connected to the radio frequency power supply, and a film deposition electric field is formed between the upper electrode assembly 110 and the lower electrode assembly 120. In specific arrangement, the number of radio frequency power supplys can be 1, 2, 3, or more. The tray 121 in the lower electrode assembly 120 carries the silicon wafers to be deposited. The process gas enters the film deposition electric field through the gas flow channel of the upper electrode assembly 110, generates plasma in the film deposition electric field, and the plasma undergoes chemical reactions to form the required amorphous silicon or microcrystalline silicon film on the surface of the silicon wafers to be deposited.

The above-mentioned vacuum film deposition apparatus 10 includes the large-area plasma discharge structure 100. By arranging a plurality of lap-jointed dielectric plates 113, the area size of the dielectric plates 113 can be arbitrarily extended, making it convenient to obtain large-area dielectric plates 113. When the large-area dielectric plates 113 are applied in the large-area plasma discharge structure 100, by arranging the dielectric plates 113 to face the recessed part 1122 of the showerhead 112 (where the recessed part 1122 has an arcuate or step-like structure), a vacuum discharge region 114 with a large central space and small edge spaces is formed between the dielectric plates 113 and the showerhead 112. This can weaken the influence of the transverse standing wave effect of the electrical signal in the radio frequency power supply, ensure the uniformity of the film deposition electric field formed between the upper electrode assembly 110 and the lower electrode assembly 120, thereby improving the uniformity of the film during the film deposition process of the large-area plasma discharge structure 100, alleviating the problem of poor film uniformity, and increasing the yield of heterojunction solar cells.

The technical features of the above-described embodiments can be combined arbitrarily. To make the description concise, not all possible combinations of the technical features in the above embodiments are described. However, as long as there is no contradiction in the combination of these technical features, they should all be regarded as the scope recorded in this specification.

The above-described embodiments only express several implementation modes of the present application, and their descriptions are relatively specific and detailed, but they should not be construed as a limitation on the scope of the patent application. It should be pointed out that for those of ordinary skill in the art, without departing from the concept of the present application, several modifications and improvements can also be made, which all belong to the protection scope of the present application. Therefore, the protection scope of the patent of the present application shall be subject to the appended claims.

## Claims

1. A large-area plasma discharge structure, **characterized in that** it comprises:
an upper electrode assembly and a lower electrode assembly, wherein a film deposition electric field is formed between the upper electrode assembly and the lower electrode assembly; the upper electrode assembly includes:
a back plate connected to a radio frequency power supply and used for introducing process gas;
a showerhead mounted on the back plate, with a recessed part on the side facing away from the back plate;
a plurality of dielectric plates detachably connected to the showerhead, wherein the side of each dielectric plate close to the showerhead faces the recessed part, and the plurality of dielectric plates are lap-jointed to form a lower surface of the entire upper electrode assembly.

2. The large-area plasma discharge structure according to claim 1, wherein the dielectric plate comprises an electrical conductor and a dielectric layer covering the surface of the electrical conductor.

3. The large-area plasma discharge structure according to claim 2, wherein the relative dielectric constant of the dielectric layer is 2-1000.

4. The large-area plasma discharge structure according to claim 3, wherein the relative dielectric constant of the dielectric layer is preferably 2-40.

5. The large-area plasma discharge structure according to claim 1, wherein the dielectric plate is made of a ceramic material.

6. The large-area plasma discharge structure according to claim 5, wherein the ceramic material is at least one selected from the group consisting of talc ceramic, forsterite ceramic, cordierite ceramic, spinel ceramic, mullite ceramic, glass ceramic, sialon ceramic, yttrium fluoride ceramic, silicon nitride ceramic, magnesium oxide ceramic, beryllium oxide ceramic, hafnium oxide ceramic, cerium oxide ceramic, boron nitride ceramic, boron carbide ceramic, aluminum oxide ceramic, yttrium oxide ceramic, aluminum nitride ceramic, silicon carbide ceramic, zirconium oxide ceramic, and bismuth oxide ceramic.

7. The large-area plasma discharge structure according to claim 1, wherein the dielectric plate has a rectangular structure, with both length and width ranging from 40 mm to 400 mm, and the thickness ranging from 0.5 mm to 10 mm.

8. The large-area plasma discharge structure according to claim 7, wherein the length and width of the dielectric plate are both ranging from 100 mm to 250 mm, and the thickness ranging from 1 mm to 5 mm.

9. The large-area plasma discharge structure according to claim 7, wherein each dielectric plate is provided with 2 upper grooves and 2 lower grooves on its four edges, and one upper groove of adjacent dielectric plates is engaged in a lap joint with one lower groove of the other dielectric plate.

10. The large-area plasma discharge structure according to claim 1, wherein the dielectric plate is provided with mounting through-holes penetrating through the dielectric plate along the thickness direction thereof; the showerhead is provided with mounting holes; and connecting fasteners pass through the mounting through-holes and the mounting holes to detachably connect the dielectric plate and the showerhead as an integral assembly.

11. The large-area plasma discharge structure according to claim 10, wherein the first end of the connecting fastener away from the showerhead does not extend beyond the surface of the dielectric plate facing away from the showerhead.

12. The large-area plasma discharge structure according to claim 1, wherein the side of the showerhead facing the dielectric plate is provided with receiving holes; the upper electrode assembly further includes positioning pins, one end of each positioning pin is located in the corresponding receiving hole, and the other end of each positioning pin abuts against the dielectric plate.

13. The large-area plasma discharge structure according to claim 1, wherein the recessed part of the showerhead has an arcuate or step-like structure, and the distance between the showerhead and the dielectric plate gradually decreases from the central area to the edge area.

14. A vacuum film deposition apparatus, **characterized in that** it comprises a vacuum chamber, a radio frequency power supply, and the large-area plasma discharge structure according to claims 1-13, wherein: the large-area plasma discharge structure is installed in the vacuum chamber, and at least one of the upper electrode assembly and the lower electrode assembly included in the large-area plasma discharge structure is connected to the radio frequency power supply.
